# EUROPÄISCHE PATENTSCHRIFT

(11) **EP 1 273 025 B1**
(45) Veröffentlichungstag und Bekanntmachung des Hinweises auf die Patenterteilung: **29.06.2005**
(21) Anmeldenummer: 01915065.5
(22) Anmeldetag: 26.02.2001
(51) Int. Cl.: H01J 37/32

(54) **VORRICHTUNG ZUM PLASMABEHANDELN DER OBERFLÄCHE VON SUBSTRATEN DURCH IONENÄTZUNG**
DEVICE FOR PLASMA-TREATING THE SURFACE OF SUBSTRATES BY ION ETCHING
DISPOSITIF DE TRAITEMENT AU PLASMA DE LA SURFACE DE SUBSTRATS PAR GRAVURE IONIQUE

(30) Priorität: 03.03.2000 DE 10010126
(43) Veröffentlichungstag der Anmeldung: 08.01.2003
(73) Patentinhaber: COBES GmbH, 79367 Weisweil (DE)
(72) Erfinder: STOLLENWERK, Johannes, 51503 Rösrath (DE)
(74) Vertreter: Goy, Wolfgang, Dipl.-Phys.
(86) Internationale Anmeldenummer: PCT/DE2001/000762
(87) Internationale Veröffentlichungsnummer: WO 2001/065587

(56) Entgegenhaltungen:
- EP-A- 0 247 397
- EP-A- 0 511 153
- DE-U- 29 615 190
- GB-A- 2 049 560

## Beschreibung

Die Erfindung betrifft eine Vorrichtung zum Verringern der Dicke von Substraten durch Ionenätzung nach dem Oberbegriff des Patentanspruchs 1.

Ein Anwendungsgebiet der Erfindung ist das Herstellen von extrem dünnen Wafern, welche immer häufiger gefordert werden. Ihre Vorteile liegen in der guten Wärmeableitung eines integrierten Schaltkreises (IC) sowie Materialersparnis für die Chipkartenindustrie. Mit den bisherigen Ionenätzverfahren können jedoch nur Chips hergestellt werden, welche relativ dick sind und daher leicht brechen können, wenn sie beispielsweise in einer Scheckkarte integriert sind.

Das Grundprinzip des Ionenätzverfahrens besteht darin, daß ein Plasma eines zugeführten Ätzgases erzeugt wird. Indem das zu behandelnde Substrat auf ein negatives Spannungspotenzial gelegt wird, werden die Ionen auf das Substrat beschleunigt und tragen somit die Oberfläche des Substrates ab. Bei den bekannten Ionenätzvertahren wird das Plasma durch Hochfrequenzeinspeisung in das Ätzgas oder durch ein Mikrowelleneinkoppelsystem oder auf andere, vergleichbare Weise erzeugt. Allerdings ist die Ionisationsrate durch diese Verfahren zur Erzeugung des Plasmas relativ gering und dementsprechend auch die Leistungsfähigkeit des Verfahrens zum Verringern der Dicke von Substraten durch Ionenätzung unbefriedigend.

Die EP 0 798 399 A1 zeigt ein Verfahren sowie eine Vorrichtung zum Beschichten von metallischen oder keramischen Substraten, bei dem mittels vier Kathoden ein magnetisch geschlossener Raum gebildet wird, in dem sich die Substratträger befinden, welche sich drehen und zusätzlich auf einem Drehteller angeordnet sind. Vor der Beschichtung findet eine Ätzbehandlung der Substratoberfläche mit Cr- und/oder Mo-Ionen statt, welche aus einer kathodischen Bogenentladungsverdampfung stammen. Diese Bogenentladung entsteht zwischen einer Kathode und einer Anode in einem ersten Stromkreis.

Die EP 0 459 137 A2 zeigt ebenfalls eine Vorrichtung zum Beschichten von Substraten unter Verwendung einer Rundmagnetanordnung, welche relativ zu einem ortsfest angebrachten Mittelpol-Permanentmagneten in Axialrichtung verschiebbar ist. In Abhängigkeit von der Relativlage zwischen der Randmagnetanordnung und dem Mittelpolmagneten wird eine Kathodenzerstäubung und/oder eine Bogenentladung realisiert. Dabei kann das Target von einer elektromagnetischen Ringspule umgeben sein. Diese elektromagnetische Spule ist insbesondere während der Phase der Kathodenzerstäubung in Betrieb. Sie kann aber auch in der Phase der Bogenentladung eingesetzt werden, um die sich auf dem Target ausbildende Bogenspur zu beeinflussen und auf diese Weise die Standzeit des Targets zu erhöhen.

Die GB 2 049 560 A zeigt ein Verfahren zum Plasmaätzen der Oberflächen von Werkstükken mittels eines Ätzgases. Zur Aktivierung des Ätzgases wird eine Bogenentladung zwischen einer thermoionischen Kathode und einer Anode verwendet. Die Werkstücke befinden sich in einer zylindrischen Anordnung auf einem Träger.

Der Erfindung liegt die **Aufgabe** zugrunde, eine leistungsfähige Vorrichtung mit hohem Wirkungsgrad zum großflächigen Verringern der Dicke auch von empfindlichen Substraten durch Ionenätzung zu schaffen.

Die technische **Lösung** ist gekennzeichnet durch die Merkmale im Kennzeichen des Patentanspruchs 1.

Dadurch ist eine leistungsfähige Vorrichtung mit hohem Wirkungsgrad für die Ionenätzung auch von empfindlichen Substraten geschaffen. Die Grundidee besteht darin, die hohe Plasmaintensität des Lichtbogens als Quelle für Ätzgasionen zu nutzen, den Lichtbogen aber räumlich vom Substrat sicher zu trennen, so daß Beschädigungen ausgeschlossen sind. Dadurch ist eine technisch einfache Möglichkeit geschaffen, um eine Verringerung der Dicke von Substraten durch Ionenätzung unter Verwendung eines Plasmas zu schaffen. Das durch die Magnetspule erzeugte wandernde Magnetfeld gewährleistet dabei die Trennung des Lichtbogens bzw. des Plasmas von dem Substrat. Zerstörerische punktuelle Überhitzungen werden durch das Wandern des Lichtbogens vermieden. Die erfindungsgemäße Vorrichtung trennt somit das Substrat vom Lichtbogen und erzeugt somit einen streng lokalisierten Lichtbogen. Dieser schädigt das Substrat nicht, sorgt aber durch seine hohe Plasmaintensität für einen ausreichend hohen Ionenstrom auf das Substrat und damit für eine hohe Ätzrate. Dadurch ist ein durch einen Lichtbogen gestütztes Plasma-Trockenätzverfahren zum Dünnen von Substraten, beispielsweise von fertig-prozessierten Wafern geschaffen, welches mit einem hohen Wirkungsgrad arbeitet. Somit kann der Forderung nach extrem dünnen Wafern Genüge getan werden, wobei die Vorteile dieser Wafer in der guten Ableitung der Wärme eines integrierten Schaltkreises (IC) erzielt werden, weiterhin eine Materialersparnis für die Herstellung der Chips sowie schließlich eine hohe Stabilität der Chips, weil sie dünn und daher sehr flexibel sind. Die erfindungsgemäße Ätzvorrichtung ermöglicht aufgrund der hohen Ionisationsraten kürzere Ätzzeiten und geringere Stückkosten, wie dies mit den bisherigen Verfahren nicht möglich ist.

Gemäß der Weiterbildung in Anspruch 2 kann die Gaszuführung als ein in etwa ringförmiges Rohr ausgebildet sein, welches gleichermaßen konzentrisch um die mittige Elektrode umläuft. Alternativ ist es auch denkbar, die Kammer mit mehreren, einzelnen Zuführdüsen zu versehen.

Eine weitere Weiterbildung in der Ausbildung der Vakuumkammer schlägt Anspruch 3 vor.

Wie zuvor bereits erwähnt, kann der Lichtbogen durch Wechselspannung gezündet und aufrecht erhalten werden. Dabei kann gemäß der Weiterbildung in Anspruch 4 bei diesem Wechselstrombetrieb des Lichtbogens die Frequenz zwischen 1 Hz und 4 MHz variabel sein, wobei ein Prozeßoptimum bei ungefähr 1,765 MHz erzielt wird.

Alternativ kann gemäß Anspruch 5 der Lichtbogen auch durch Gleichspannung gezündet und aufrecht erhalten werden.

Eine weitere Weiterbildung schlägt Anspruch 6 vor, wobei die Grundidee in einer gepulsten DC-Vorspannung (DC-Bias) liegt. Die Frequenz der gepulsten Gleichstromquelle ist dabei variabel im Bereich zwischen 1 Hz und 1 MHz, wobei der beste Arbeitspunkt bei ungefähr 225 KHz liegt. Die Grundidee liegt darin, daß die durch den Lichtbogen erzeugten Ionen mittels eines Spannungsimpulses auf das Substrat beschleunigt werden.

Eine Weiterbildung hiervon schlägt Anspruch 7 vor. Die Grundidee liegt darin, daß durch das positive Spannungspotential entstandene partielle Raumladungen entfernt werden, welche ansonsten das angelegte negative Potential stören würden. Der Raum wird somit entladen und von Ladungsträgern bereinigt. Vorzugsweise ist dabei der positive Gegenpuls kürzer als der negative Spannungspuls.

Um die gewünschte und geforderte extrem hohe lonisations- sowie Ätzrate zu erzielen, können gemäß der Weiterbildung in Anspruch 8 als Ätzgas Fluorverbindungen verwendet werden. Diese bewirken nicht nur hohe lonisations- sowie Ätzraten bei Silizium, sondern auch bei SiO₂, Si₃N₄, Al, MO, Ta, Ti sowie W.

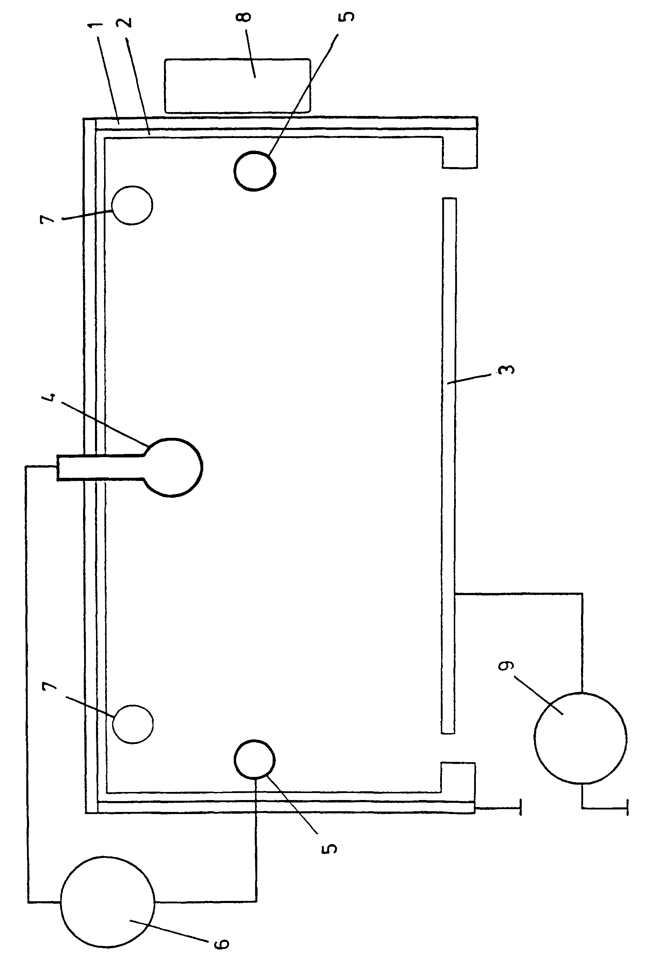

Ein Ausführungsbeispiel der erfindungsgemäßen Vorrichtung zum Verringern der Dicke von Substraten, nämlich eines Wafers, durch Ionenätzung wird unter Bezugnahme auf die Zeichnung beschrieben, welche einen schematischen Längsschnitt durch die Vorrichtung zeigt.

Das Ätzmodul weist eine zylinderförmige Vakuumkammer 1 auf. Diese ist innenseitig mit einer Beschichtung 2 aus heißgepreßtem Bomitrit versehen. Im unteren Bereich dieser Vakuumkammer 1 befindet sich das zu behandelnde Substrat 3 in Form eines Wafers.

Innerhalb der Vakuumkammer 1 befindet sich im zentralen Deckenbereich eine erste Elektrode 4. Dazu konzentrisch ist im Wandbereich der Vakuumkammer 1 eine zweite, ringförmige Elektrode 5 angeordnet. Beide Elektroden 4, 5 sind an eine Wechselspannungsquelle angeschlossen, welche variabel im Frequenzbereich zwischen 1 Hz und 4 MHz arbeitet. Außerdem ist oberhalb der ringförmigen Elektrode 5 eine Gaszuführung 7 in Form eines Ringrohres angeordnet, welches um den Umfang verteilt Austrittsdüsen für ein Ätzgas aufweist, bei dem es sich insbesondere um eine Fluorverbindung handelt.

Außerhalb der Vakuumkammer 1 befinden sich noch ringförmig angeordnete Magnetspulen zur Erzeugung eines rotierenden Magnetfeldes.

Schließlich ist das Substrat 3 an eine Spannungsquelle 9 zur Erzeugung einer negativ gepulsten Gleichstromvorspannung (Pulsed DC Bias) angeschlossen, welche im Frequenzbereich zwischen 1 Hz und 1 MHz arbeitet.

Die Funktionsweise des Ätzmoduls ist wie folgt:

Die Vakuumkammer 1 ist auf einen Druck zwischen 0,001 und 10 mbar evakuiert, wobei der bevorzugte Arbeitsdruck bei ungefähr 0,5 mbar liegt. Andere Drücke sind jedoch auch denkbar.

Durch die Gaszuführung 7 wird Ätzgas in Form einer Fluorverbindung in die Vakuumkammer 1 eingelassen. Da zwischen den beiden Ektroden 4, 5 eine Wechselspannung oder Gleichspannung anliegt, wird ein Lichtbogen mit einem Plasma zwischen diesen beiden Elektroden 4, 5 erzeugt. Die Magnetspulen 8 werden dabei derart aktiviert, daß der Lichtbogen längs der ringförmigen Elektrode 5 karussellartig umläuft.

Sobald die Spannungsquelle 9 einen negativen Spannungsimpuls abgibt, werden die Ionen des Plasmas auf das Substrat 3 beschleunigt. Bei Auftreffen der Ionen auf die Oberseite des Substrats 3 wird diese Oberfläche geäzt, d.h. abgetragen und zwar so lange, bis die gewünschte Dicke erreicht ist. Zwischen den negativen Gleichspannungspulsen der Spannungsquelle 9 werden vorzugsweise kürzere, positive Gleichspannungspulse erzeugt. Diese bewirken, daß partielle Raumladungen entfernt werden und somit das anschließend angelegte negative Potential nicht durch eine eventuelle Raumladung gestört wird.

Das Verfahren besteht somit in der Trennung von Plasma und Lichtbogen sowie Substrat 3 und Lichtbogen. Der Lichtbogen, gespeist durch eine elektrische Versorgung, dient als lonisationsquelle für das Plasma, dessen Ionen dann durch eine zweite pulsierende Spannung auf das Substrat 3 beschleunigt werden. Die Trennung von Substrat 3 und Lichtbogen geschieht über das wandernde Magnetfeld. Somit wird der Lichtbogen nicht auf das Substrat 3 beschleunigt. Der Lichtbogen und das Substrat 3 sind voneinander getrennt. Der Lichtbogen dient der Erzeugung des Plasmas.

Der Vorteil dieses Ätzmoduls zur großflächigen Bearbeitung liegt darin, daß durch die extrem hohe Ionisationsrate und der negativ gepulsten Gleichstrom-Vorspannung (Pulsed DC Bias) eine im Vergleich zum Stand der Technik weit höhere Ätzrate/Abtragsrate erreicht wird. Daraus resultieren sehr kurze Ätzzeiten und damit geringere Stückkosten, wie dies bisher möglich war. Insgesamt können damit extrem dünne Wafer geschaffen werden, welche sich durch eine gute Ableitung der Wärme des integrierten Schaltkreises (IC) auszeichnen, weiterhin durch eine Materialersparnis für die Chipkartenindustrie sowie schließlich durch die Bereitstellung von flexiblen Chips, welche ohne weiteres in Scheckkarten eingebettet werden können, ohne daß die Gefahr eines Bruches bei einer Biegebeanspruchung entsteht.

### Bezugszeichenliste

- 1: Vakuumkammer
- 2: Beschichtung
- 3: Substrat
- 4, 5: Elektroden
- 6: Wechselspannungsquelle
- 7: Gaszuführung
- 8: Magnetspule
- 9: Spannungsquelle

## Patentansprüche

1. Vorrichtung zum Verringern der Dicke von Substraten (3) durch lonenätzung,
mit einer Vakuumkammer (1),
mit zwei Elektroden (4,5), zwischen denen eine Gleich- oder Wechselspannung zur Erzeugung eines Plasmas eines Ätzgases durch einen Lichtbogen anlegbar ist, sowie mit einer Ätzgaszuführung (7),
wobei die Ionen des Ätzgases durch ein elektrisches Potential auf das Substrat (3) beschleunigbar sind,
**dadurch gekennzeichnet,**
**daß** die erste Elektrode (5) ringförmig ausgebildet ist,
**daß** die zweite Elektrode (4) etwa auf der Mittelachse des Ringes der ersten Elektrode (5) angeordnet ist,
**daß** das Substrat (3) symmetrisch auf der Mittelachse des Ringes der ersten Elektrode (5) angeordnet ist,
**daß** das Elektroden-Paar (4,5) zwischen der Ätzgaszuführung (7) auf der eine Seite und dem Substrat (3) auf der anderen Seite angeordnet ist,
**daß** der Vakuumkammer (1) eine Magnetspule (8) zur Erzeugung eines derart wandernden Magnetfeldes zugeordnet ist, daß im Gebrauch der Vorrichtung der zwischen den beiden Elektroden (4,5) erzeugbare Lichtbogen längs der ringförmigen Elektrode (5) karusellartig umläuft und vom Substrat (3) örtlich getrennt ist.

2. Vorrichtung nach dem vorhergehenden Anspruch,
**dadurch gekennzeichnet,**
**daß** die Gaszuführung (7) als ein in etwa ringförmiges Rohr ausgebildet ist.

3. Vorrichtung nach einem der vorhergehenden Ansprüche,
**dadurch gekennzeichnet,**
**daß** die Innenwand der Vakuumkammer (1) heißgepresstes Bornitrid aufweist.

4. Vorrichtung nach einem der Ansprüche 1 bis 3,
**dadurch gekennzeichnet,**
**daß** der Lichtbogen durch Wechselspannung insbesondere mit einer Frequenz zwischen 1 Hz und 4 MHz und dabei insbesondere mit ungefähr 1,765 MHz zündbar und aufrechterhaltbar ist.

5. Vorrichtung nach einem der Ansprüche 1 bis 3,
**dadurch gekennzeichnet,**
**daß** der Lichtbogen durch Gleichspannung zündbar und aufrechterhaltbar ist.

6. Vorrichtung nach einem der vorhergehenden Ansprüche,
**dadurch gekennzeichnet,**
**daß** das Substrat (3) auf ein negatives, gepulstes Spannungspotential, insbesondere Gleichspannungspotential, insbesondere mit einer Frequenz zwischen 1 Hz und 1 MHz und dabei insbesondere bei 225 KHz legbar ist.

7. Vorrichtung nach Anspruch 6,
**dadurch gekennzeichnet,**
**daß** zwischen den negativen Spannungspulsen das Substrat (3) auf ein positives Spannungspotential legbar ist.

8. Vorrichtung nach einem der vorhergehenden Ansprüche,
**dadurch gekennzeichnet,**
**daß** das Ätzgas eine Fluorverbindung ist, insbesondere SF₆, NF₃, CF₄ oder C₃F₈.

## Claims

1. Device for reducing the thickness of substrates (3) by ion etching,
with a vacuum chamber (1),
with two electrodes (4, 5) between which can be applied a DC or AC voltage to generate a plasma of an etching gas by an arc, and
with an etching gas supply (7),
where the ions of the etching gas can be accelerated onto the substrate (3) by an electrical potential,
**characterised in that**
the first electrode (5) is formed annular,
**in that** the second electrode (4) is arranged approximately on the centre axis of the ring of the first electrode (5),
**in that** the substrate (3) is arranged symmetrically on the centre axis of the ring of the first electrode (5),
**in that** the electrode pair (4, 5) is arranged between the etching gas supply (7) on the one side and the substrate (3) on the other side,
**in that** allocated to the vacuum chamber (1) is a magnetic coil (8) to generate a magnetic field which wanders such that on use of the device the arc that can be generated between the two electrode (4, 5) circulates carousel-like along the annular electrode (5) and is spatially separated from the substrate (3).

2. Device according to the previous claim, **characterised in that** the gas supply (7) is formed as an approximately annular tube.

3. Device according to any of the previous claims, **characterised in that** the inner wall of the vacuum chamber (1) comprises hot-pressed boron nitride.

4. Device according to any of claims 1 to 3, **characterised in that** the arc can be ignited and maintained by AC voltage, especially with a frequency between 1 Hz and 4 MHz and in particular around 1.765 MHz.

5. Device according to any of claims 1 to 3, **characterised in that** the arc can be ignited and maintained by a DC voltage.

6. Device according to any of the previous claims, **characterised in that** the substrate (3) can be laid to a negative pulsed voltage potential, in particular a DC voltage potential, especially with a frequency between 1 Hz and 1 MHz and in particular at 225 KHz.

7. Device according to claim 6, **characterised in that** between the negative voltage pulses the substrate (3) can be laid to a positive voltage potential.

8. Device according to any of the previous claims, **characterised in that** the etching gas is a fluorine compound, in particular SF₆, NF₃, CF₄ and C₃F₈.

## Revendications

1. Dispositif pour réduire l'épaisseur de substrats (3) par gravure ionique,
avec une chambre à vide (1),
avec deux électrodes (4, 5) entre lesquelles on peut appliquer une tension continue ou alternative pour générer un plasma d'un gaz de gravure par un arc électrique, et
avec une arrivée de gaz de gravure (7),
les ions du gaz de gravure pouvant être accélérés sur le substrat (3) par un potentiel électrique,
**caractérisé par le fait**
**que** la première électrode (5) est en forme d'anneau,
**que** la deuxième électrode (4) est disposée à peu près sur l'axe médian de l'anneau de la première électrode (5),
**que** le substrat (3) est disposé de façon symétrique sur l'axe médian de l'anneau de la première électrode (5),
**que** la paire d'électrodes (4, 5) est disposée entre l'arrivée de gaz de gravure (7) d'un côté et le substrat (3) de l'autre côté,
**qu'**à la chambre à vide (1) est associé un solénoïde (8) pour générer un champ magnétique migrant de telle manière que l'arc électrique pouvant être généré entre les deux électrodes (4, 5) lors de l'utilisation du dispositif circule à la manière d'un carrousel le long de l'électrode (5) en forme d'anneau et est spatialement séparé du substrat (3).

2. Dispositif selon la revendication précédente,
**caractérisé par le fait**
**que** l'arrivée de gaz de gravure (7) est constituée d'un tube à peu près en forme d'anneau.

3. Dispositif selon l'une des revendications précédentes,
**caractérisé par le fait**
**que** la paroi intérieure de la chambre à vide (1) présente du nitrure de bore pressé à chaud.

4. Dispositif selon l'une des revendications 1 à 3,
**caractérisé par le fait**
**que** l'arc électrique peut être allumé et maintenu par une tension alternative en particulier à une fréquence comprise entre 1 Hz et 4 MHz et en particulier à environ 1,765 MHz.

5. Dispositif selon l'une des revendications 1 à 3,
**caractérisé par le fait**
**que** l'arc électrique peut être allumé et maintenu par une tension continue.

6. Dispositif selon l'une des revendications précédentes,
**caractérisé par le fait**
**que** le substrat (3) peut être mis à un potentiel de tension pulsé négatif, en particulier à un potentiel de tension continue, en particulier à une fréquence comprise entre 1 Hz et 1 MHz et en particulier à 225 kHz.

7. Dispositif selon la revendication 6,
**caractérisé par le fait**
**qu'**entre les impulsions de tension négatives, le substrat (3) peut être mis à un potentiel de tension positif.

8. Dispositif selon l'une des revendications précédentes,
**caractérisé par le fait**
**que** le gaz de gravure est un composé fluoré, en particulier SF₆, NF₃, CF₄ ou C₃F₈.
